**Europäisches Patentamt**

**European Patent Office**

**Office européen des brevets**

(19)

(11) Publication number: **0 067 226**

**A1**

(12) **EUROPEAN PATENT APPLICATION**

published in accordance with Art. 158(3) EPC

(21) Application number: **81902593.3**

(22) Date of filing: **16.09.81**

Data of the international application taken as a basis:

(86) International application number:
**PCT/JP81/00233**

(87) International publication number:
**WO82/01073 (01.04.82 82/09)**

(51) Int. Cl.³: **G 01 P 3/44**
**G 01 P 3/46, G 01 P 3/48**
**H 02 K 29/02, H 02 K 21/00**

(30) Priority: **17.09.80 JP 127878/80**

(43) Date of publication of application:
**22.12.82 Bulletin 82/51**

(84) Designated Contracting States:
**DE FR GB**

(71) Applicant: **Fanuc Ltd**
**5-1, Asahigaoka, 3-chome**
**Hino-shi, Tokyo 191(JP)**

(72) Inventor: **KOZAI, Yoshinori**
**16-3, Hirayama, 2-chome Hino-shi**
**Tokyo 191(JP)**

(72) Inventor: **AMEMIYA, Yoichi**
**1019-357, Nishite-Rakatamachi Haichioji-shi**
**Tokyo 192-01(JP)**

(72) Inventor: **IWAMATSU, Noboru**
**3-27, Tamadaira Hino-shi**
**Tokyo 191(JP)**

(74) Representative: **Blumbach Weser Bergen Kramer**
**Zwirner Hoffmann Patentanwälte**
**Radeckestrasse 43**
**D-8000 München 60(DE)**

(54) **D.C. GENERATOR TYPE NON-CONTACT SPEED SENSING DEVICE.**

(57) In a D.C. generator type non-contact speed sensing device comprising a cylindrical magnet-rotor with N and S poles alternating around the periphery and a stator with windings wound confronting the rotor, the non-uniformity in the magnetization of the magnet causes the non-uniformity in the magnetic flux density in the vicinity of the surface of the pole, so that the electromotive force induced in the windings fluctuates, resulting in an inaccurate speed sensing. To overcome the problem, a rotor is constructed out of a permanent magnet (11) with magnetic poles aligned with the axial direction and yoke members (12), (13) each of which is composed of a plane portion (15) in contact with the pole-surface of the magnet and an elongated portion (16) normal to the plane portion and of such a form as covers the peripheral surface of the side-portion of the magnet. Thus, the magnetic flux density over the surface of the yoke is made uniform and the fluctuation in the electromotive force induced in the windings, caused by the non-uniformity in magnetization, is eliminated.

Fig. 4 (A) (B) (C)

Croydon Printing Company Ltd.

- 1 -

DESCRIPTION

TITLE OF THE INVENTION

A Non-contacting Speed Detecting Device of a
Direct-current Generator Type

TECHNICAL FIELD

The present invention relates to a non-contacting speed detecting device of a direct-current generator type, and especially to the above-mentioned device which uses a yoke member in order to equalize the distribution of the magnetic flux density in the magnetic pole of the rotator.

BACKGROUND ART

Conventionally, there is known as a non-contacting speed detecting device of a DC generator type, a device wherein a generator, comprising a rotator consisting of a cylidrical permanent magnet having a plurality of magnetic poles along the circumferential direction and stator windings arranged along the circumference of said rotator, is designed to gain a DC voltage by switching multi-phased trapezoidal waveform AC voltages obtained from the respective phases of the stator windings in their flat portions.

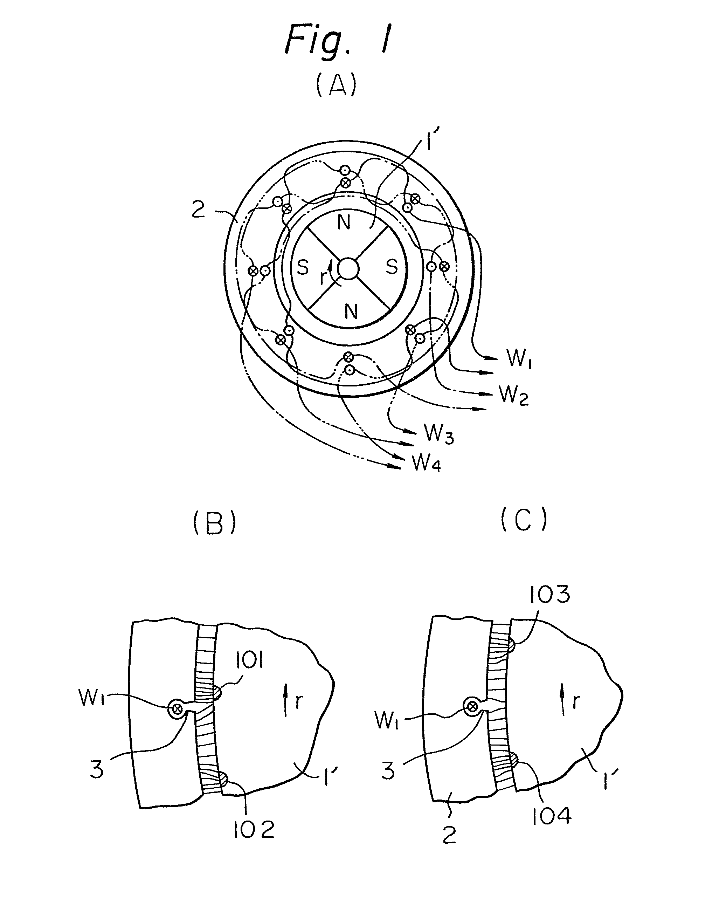

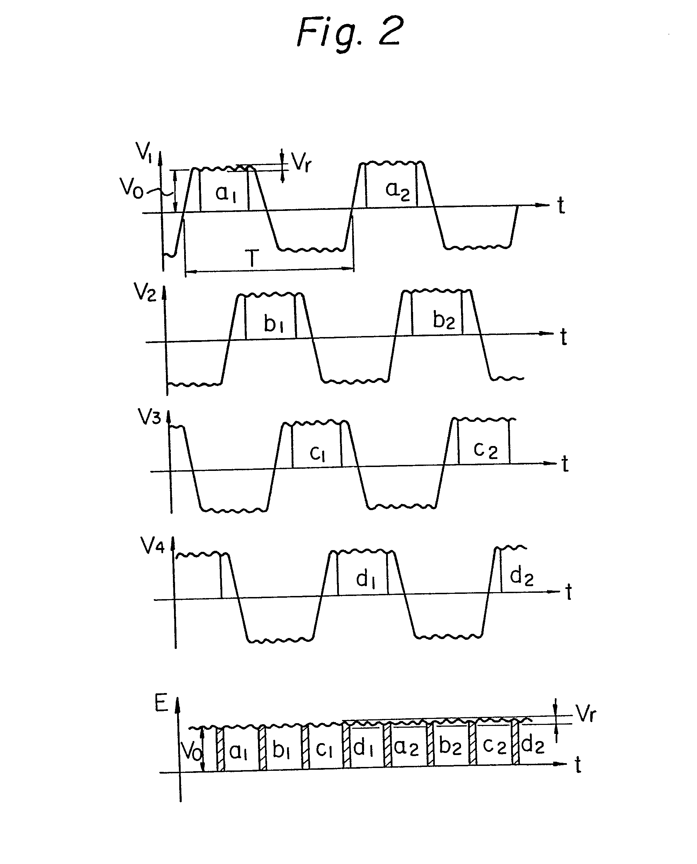

The above-mentioned speed detecting device of a prior art is illustrated in Fig. 1 (A), (B) and (C). Various voltage waveforms in the speed detecting device of Fig. 1 are illustrated in Fig. 2. In Fig. 1 (A), a rotator 1' consists of a permanent magnet having four magnetic poles in its circumferential face and its axis is coupled to the axis of a rotating body to be measured. A stator 2 has a stator core and four phases of stator windings $W_1$, $W_2$, $W_3$ and $W_4$ wound through the slot portions of said stator core. When the rotator 1' rotates in the direction of the arrow r, shown in Fig. 1, alternating voltages, shown in Fig. 2 as $V_1$, $V_2$, $V_3$ and $V_4$, are produced in the respective phases $W_1$, $W_2$, $W_3$ and $W_4$ of the windings wound in the stator. The waveforms of the respective phases are shifted by 90° in phase in the order of $V_1$, $V_2$, $V_3$ and $V_4$. Each of the waveforms has an approximately trapezoidal shape in half of each cycle, as shown in Fig. 2. Accordingly, the value of the voltage is an approximately constant value $V_0$ in the central portion of said trapezoidal waveform. Furthermore, this constant voltage value $V_0$ is directly proportional to the rotating speed of the rotator 1'. The cycle time T of each waveform is inversely proportional to the rotating speed of the rotator 1'. By switching selectively only the above-mentioned portions where the voltage value is constant in the waveform of each phase and inputing said portions into an amplifier circuit, a DC voltage output proportional to the rotating speed of the rotator 1' is obtained. The output waveform, obtained in the above--mentioned manner, is shown as E in Fig. 2. At the portion where the outputs of two phases are overlapped, the output voltage is adjusted to become the mean value between these output voltages of two phases. The variance component, existing in the flat portion of the waveform of each phase, appears in the above-mentioned DC output waveform as shown in E of Fig. 2.

By the way, in the speed detecting device of Fig. 1, a voltage variance Vr of about 5% occurs because of the following reason. There is an inequality of the magnetization in the magnetic pole of the permanent magnet, generally due to the manufacturing method, and, therefore, there also occurs an inequality in the distribution of the magnetic flux density on the surface of the magnetic pole. The distribution of the magnetic flux density near the stator winding $W_1$ wound in the slot 3 is shown in Fig. 1 (B) and (C), in which Fig. 1 (B) illustrates the case where a portion in which the magnetic flux density, being relatively high, passes near the winding and Fig. 1 (C) illustrates the case where a portion in which the magnetic flux density, being relatively low, passes near the winding. In Fig. 1 (B) and 1 (C), 101, 102, 103 and 104 indicate portions where the magnetization is relatively great. When the rotator 1' rotates at a constant speed, the electromotive force generated in the stator winding in the case of Fig. 1 (B) is greater than that in the case of Fig. 1 (C). Therefore, a variance according to the inequality in the magnet occurs in the voltage signal E indicating the speed, so that the detection of the speed becomes inaccurate. This variance causes trouble, especially when a very small speed is detected. In order to improve this problem, there is proposed a structure in which a pole shoe is attached to the magnetic pole portion of the rotator; however, the inequality of the magnetic flux density cannot be removed completely by this means.

DISCLOSURE OF THE INVENTION

The main object of the present invention is to minimize the above-mentioned problem in the prior art, on the basis of the idea of equalizing the distribution of the magnetic flux density on the surface of the magnetic pole of the rotator by using, as a stator, such a structure in which yokes, having a desired pole number of magnetic poles, are attached to a permanent magnet having its polarity along its axis direction; to remove the variance component in the output voltage of a non-contacting speed detecting device of a DC generator type, which is generated by the inequality of the magnetic flux; and to improve the precision of the speed detection.

In accordance with the present invention, there is provided a non-contacting speed detecting device of a DC generator type, comprising a cylindrical rotater magnet having an alternating distribution of the N and S poles along the circumferential direction, a stator opposite to said rotator magnet, and stator windings wound in said stator, wherein a permanent magnetic, having its polarity along the axial direction, is used for said rotator magnet, a yoke member extending from the ends of said permanent magnet in its axial direction to the positions at which said yoke covers the lateral circumferential surface of said permanent magnet is formed, and said stator windings are arranged so that they face said yoke member.

BRIEF DESCRIPTION OF DRAWINGS

Figs. 1 (A), (B) and (C) illustrate a non-contacting speed detecting device of a DC generator type of a prior art;

Fig. 2 illustrates various voltage waveforms in the speed detecting device in Fig. 1;

Fig. 3 illustrates a non-contacting speed detecting device of a DC generator type in accordance with one embodiment of the present invention;

Figs. 4 (A), (B) and (C) illustrate the structure of the rotator used in the speed detecting device of Fig. 3; and

Figs. 5 (A) and (B) illustrate the distribution of the magnetic flux density between the magnetic pole of the rotator and the stator core in the speed detecting device of Fig. 3.

BEST MODE OF CARRYING OUT THE INVENTION

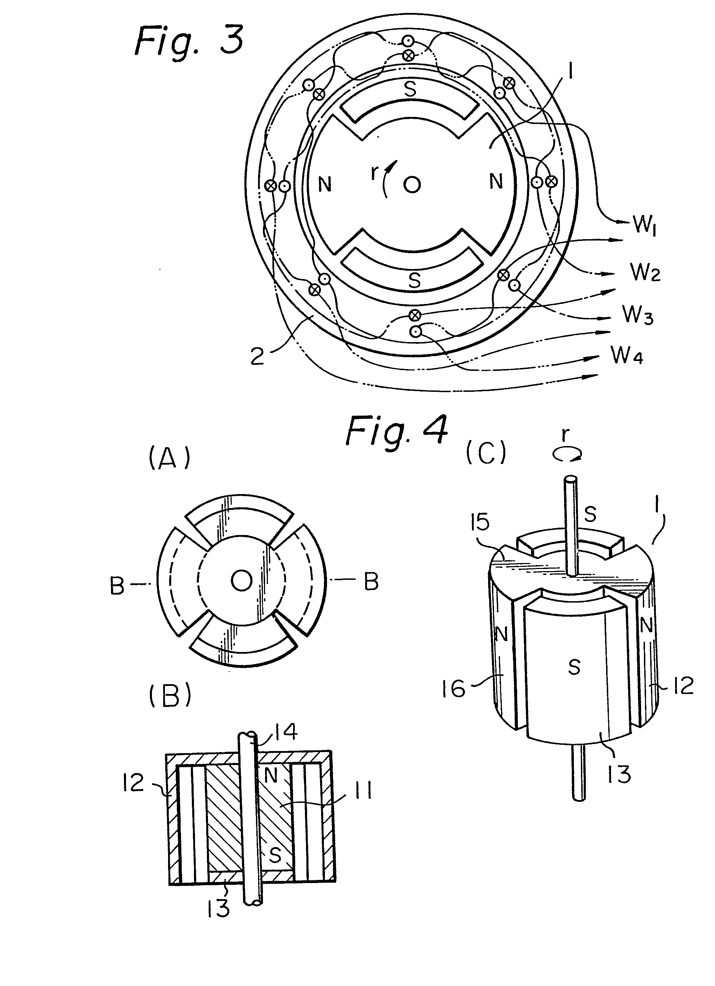

A non-contacting speed detecting device of a DC generator type, in accordance with one embodiment of the present invention, is illustrated in Fig. 3 and Figs. 4 (A), (B) and (C).

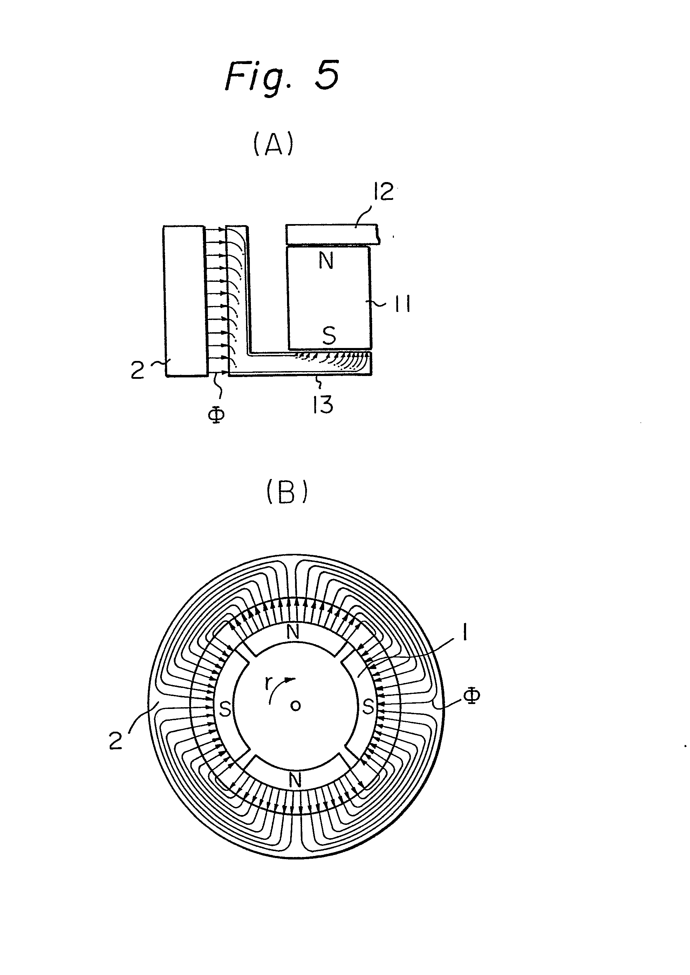

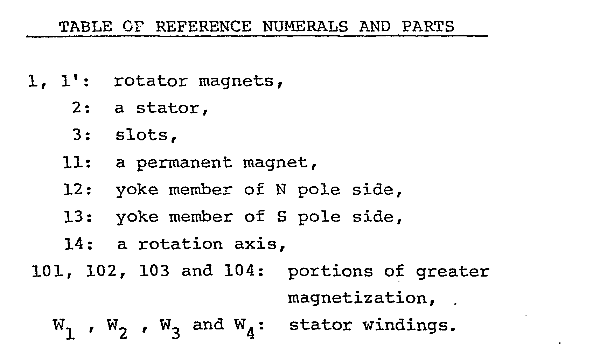

In Fig. 3, a rotator 1 according to the present invention and a stator 2 in which windings $W_1$, $W_2$, $W_3$ and $W_4$ are wound, are illustrated. In Figs. 4 (A), (B) and (C), the structure of the rotator 1 of Fig. 3 is illustrated in detail. The rotator 1 consists of a permanent magnet 11, a yoke member 12 of the N pole side, a yoke member 13 of the S pole side and a rotation axis 14. The yoke members 12, 13 of the N and S pole sides have the same shapes, and each has a flat plane portion 15 contacting the magnetic pole surface of the permanent magnet 11, and a magnetic pole portion 16 vertical to the flat plane portion 15 and extending in a fashion so that it covers the lateral circumferential surface of the permanent magnet. This magnetic pole portion 16 is arranged to form the N poles and the S poles alternatively in the cylindrical surface coaxial to the permanent magnet 11. The speed detecting device of Fig. 3 differs from the speed detecing device of a prior art of Fig. 1 in the point that the magnet pole portion of the stator 1, which portion is opposite to the stator, is formed from the yoke member. In Figs. 5 (A) and (B), the distribution of the magnetic flux density produced between the magnetic pole portion 16 formed from the yoke and the stator core 2 is illustrated. As illustrated in Fig. 5 (A), the distribution of the magnetic flux density on the surface of the magnetic pole of the rotator is given from the end magnetic pole surface of the permanent magnet 11 through the magnetic material forming the yoke, and, therefore, it is equalized. In Fig. 5 (B), the distribution of the magnetic flux density between the rotator 1 and the stator 2, which distribution is equalized according to the present invention, is illustrated.

In accordance with the speed detecting device according to the present invention illustrated in Fig. 3, the voltage variance in the output waveform of each phase shown in Fig. 2, in the case of the speed detecting device of a prior art, can be decreased remarkably. Therefore, the finally obtained output voltage of the speed detecting device has a DC waveform in which the variance component is extremely small for a constant rotating speed.

Furthermore, in the above-mentioned embodiment, the device, in which the number of the magnetic poles of the rotator is four, is described; however, of course the number of the magnetic poles of the rotator may be two or six.

According to the present invention, in the non--contacting speed detecting device of a DC generator type, the distribution of the magnetic flux density between the magnetic pole portion of the rotator and the stator core can be equalized and the variance component of the output voltage can be removed, so that the precision of the speed detecting can be improved.

CLAIMS

1. A non-contacting speed detecting device of a direct-current generator type, comprising a cylindrical rotator magnet having an alternating distribution of the N and S poles along the circumferential direction, a stator opposite to said rotator magnet, and stator windings wound on said stator; wherein a permanent magnet, having its polarity along its axial direction, is used for said rotator magnet; a yoke member, extending from the ends of the axial direction of said permanent magnet to the position at which said yoke covers the lateral circumferential surface of said permanent magnet, is formed; and said stator windings are arranged so that they face said yoke member.

2. A non-contacting speed detecting device of a direct-current generator type as claimed in Claim 1, wherein said yoke member comprises a flat plane portion contacting the end of the axial direction of said permanent magnet and a magnetic pole portion of a predetermined pole number arranged in the fashion that said portion covers the lateral circumferential surface of said permanent magnet.

3. A non-contacting speed detecting device of a direct-current generator type as claimed in Claim 2, wherein said predetermined pole number of said yoke member is 2.

4. A non-contacting speed detecting device of a direct-current generator type as claimed in Claim 2, wherein said predetermined pole number of said yoke member is 4.

5. A non-contacting speed detecting device of a direct-current generator type as claimed in Claim 2, wherein said predetermined pole number of said yoke member is 6.

6. A non-contacting speed detecting device of a direct-current generator type as claimed in anyone of Claims 1 through 5, wherein two sections of said yoke member, extending respectively from the N pole and the S pole ends of said permanent magnet, have the same shape.

# Fig. 1

### (A)

### (B)          (C)

# Fig. 2

*Fig. 3*

*Fig. 4*

(A)

(C)

(B)

# Fig. 5

## (A)

## (B)

## TABLE OF REFERENCE NUMERALS AND PARTS

1, 1': rotator magnets,

2: a stator,

3: slots,

11: a permanent magnet,

12: yoke member of N pole side,

13: yoke member of S pole side,

14: a rotation axis,

101, 102, 103 and 104: portions of greater magnetization,

$W_1$, $W_2$, $W_3$ and $W_4$: stator windings.

**I. CLASSIFICATION OF SUBJECT MATTER** (if several classification symbols apply, indicate all) [3]

According to International Patent Classification (IPC) or to both National Classification and IPC

Int. Cl.[3]   G01P 3/44, G01P 3/46, G01P 3/48, H02K 29/02, H02K 21/00

**II. FIELDS SEARCHED**

Minimum Documentation Searched [4]

| Classification System | Classification Symbols |
|---|---|
| I P C | G01P 3/44, G01P 3/46, G01P 3/48, H02K 29/02, H02K 21/00 |

Documentation Searched other than Minimum Documentation
to the Extent that such Documents are Included in the Fields Searched [5]

| | |
|---|---|
| Jitsuyo Shinan Koho | 1935 - 1981 |
| Kokai Jitsuyo Shinan Koho | 1971 - 1981 |

**III. DOCUMENTS CONSIDERED TO BE RELEVANT** [14]

| Category * | Citation of Document, [16] with indication, where appropriate, of the relevant passages [17] | Relevant to Claim No. [18] |
|---|---|---|
| A | JP,A, 50-71365   1975-6-13 Nippon Electric Co., Ltd. | 1 |
| A | JP,A, 53-106179   1978-9-14 Electrocraft Corporation | 1 |
| A | US,A, 3903462   1975-9-2   Siemens A.G. | 1 |
| A | GB,A, 913170   1960-10-6   FeRRANTI Ltd. | 1 |
| A | JP,A, 56-14951   1981-2-13 FUJITSU FANUC LIMITED | 1 |
| A | JP,A, 47-40105   1972-12-9 YOKOGAWA ELECTRIC WORKS, LTD. | 1 |
| A | US,A, 3646376   1972-2-29   G.E. | 2 - 6 |
| A | JP,U, 53-66980   1978-6-5   Chudo Kenkyusho | 2 - 6 |
| A | JP,B1, 32-8015   1957-9-24 Westinghouse Electric Corporation | 2 - 6 |
| A | JP,U, 52-25575   1977-2-23 Matsushita Electric Industrial Co., Ltd. | 2 - 6 |

\* Special categories of cited documents: [15]

"A" document defining the general state of the art

"E" earlier document but published on or after the international filing date

"L" document cited for special reason other than those referred to in the other categories

"O" document referring to an oral disclosure, use, exhibition or other means

"P" document published prior to the international filing date but on or after the priority date claimed

"T" later document published on or after the international filing date or priority date and not in conflict with the application, but cited to understand the principle or theory underlying the invention

"X" document of particular relevance

**IV. CERTIFICATION**

| Date of the Actual Completion of the International Search [‡] | Date of Mailing of this International Search Report [‡] |
|---|---|
| December 9, 1981 (09.12.81) | January 7, 1982 (07.01.82) |
| International Searching Authority [1] | Signature of Authorized Officer [20] |
| Japanese Patent Office | |

Form PCT/ISA/210 (second sheet) (October 1977)